(19) 

Europäisches
Patentamt
European
Patent Office
Office européen
des brevets

(11) **EP 3 163 876 A1**

(12) **EUROPEAN PATENT APPLICATION**
published in accordance with Art. 153(4) EPC

(43) Date of publication:
**03.05.2017 Bulletin 2017/18**

(21) Application number: **15815210.8**

(22) Date of filing: **29.06.2015**

(51) Int Cl.:
*H04N 19/13* (2014.01)  *H04N 19/50* (2014.01)

(86) International application number:
**PCT/KR2015/006621**

(87) International publication number:
**WO 2016/003130 (07.01.2016 Gazette 2016/01)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **29.06.2014 US 201462018644 P**

(71) Applicant: **LG Electronics Inc.
Yeongdeungpo-Gu
Seoul 150-721 (KR)**

(72) Inventors:
• **SAID, Amir
San Jose, California 95131 (US)**
• **MAHFOODH, Abo Talib
San Jose, California 95131 (US)**

(74) Representative: **Diehl & Partner GbR
Patentanwälte
Erika-Mann-Strasse 9
80636 München (DE)**

(54) **METHOD AND APPARATUS FOR PERFORMING ARITHMETIC CODING BY LIMITED CARRY OPERATION**

(57)    Disclosed herein is a method of performing an arithmetic coding for data symbols, comprising: creating an interval for each of the data symbols, the interval being represented based on a starting point and a length of the interval; updating the interval for each of the data symbols; checking whether the updated interval is included in a specific range; and renormalizing the updated interval based on a result of the checking.

[Abstract as Published in WO2016/003130 A1]

Disclosed is a method for performing arithmetic coding on data symbols, the method comprising the steps of: generating sections for respective data symbols, wherein the sections are expressed based on the starting point and length of the sections; updating the sections for the respective data symbols; checking whether or not the updated sections fall within a predetermined range; and renormalizing the updated sections on the basis of the result of the check.

【Figure 9】

$$D = 2^R \left\lfloor 1 + B/2^R \right\rfloor$$

(a)    (b)

$B + L$

$B$

$L \leftarrow D - B$

$L \leftarrow B + L - D$
$B \leftarrow D$

$$C = 2^R \left\lfloor B/2^R \right\rfloor$$

EP 3 163 876 A1

**Description**

[Technical Field]

The present invention relates to a method and apparatus for processing a video signal and, more particularly, to a technology for performing an arithmetic coding with constrained carry operations.

[Background Art]

Entropy coding is the process of representing data with the smallest average number of bits, and thus is a fundamental technique on all media compression methods. Arithmetic coding is an entropy coding method that has higher computational complexity than other coding techniques like prefix-coding (e.g., Huffman, Rice, exp-Golomb codes), but since it yields better compression (near the theoretical limits), it has been adopted as the unique entropy coding method in the recent video coding standards H.265/HEVC and VP9, and thus is expected to be the sole entropy coding method of future standards.

[Disclosure]

[Technical Problem]

There are several options for practically implementing arithmetic coding, and each can have advantages and disadvantages depending if the implementation is done in general purpose processors and conventional software tools, or specialized hardware (ASICs).

Thus, the present invention defines a technique that enables an implementation of arithmetic coding based on byte-renormalization to be effectively implemented in either general purpose or specialized hardware.

One problem for custom hardware is that, after a data symbol is encoded, the maximum number of changes to the compressed data bytes can be unbounded. Accordingly, the present invention provides a method to effectively limit this number, with little loss in compression.

[Technical Solution]

An embodiment of the present invention defines a technique that enables an implementation of arithmetic coding based on byte-renormalization to be effectively implemented in either general purpose or specialized hardware.

Furthermore, the present invention provides a method to effectively limit the maximum number of changes to the compressed data bytes with little loss in compression.

Furthermore, the present invention provides a method to adjust the interval.

Furthermore, the present invention provides a method to perform the delayed decisions for interval renormalization.

Furthermore, the present invention provides a method to perform the decision constrained to buffer values.

Furthermore, the present invention provides a method to eliminate the possibility of overflow in the extended-precision register, or equivalently overflow in the buffer with outstanding bits.

[Advantageous Effects]

The present invention can effectively implement in either general purpose or specialized hardware, by enabling an implementation of arithmetic coding based on byte-renormalization.

Furthermore, the present invention can effectively limit the maximum number of changes to the compressed data bytes with little loss in compression.

[Description of Drawings]

FIGS. 1 and 2 illustrate schematic block diagrams of an encoder and decoder which process a video signal in accordance with embodiments to which the present invention is applied.

FIG. 3 is a flowchart illustrating sets of operations required for updating arithmetic coding interval data in accordance with an embodiment to which the present invention is applied.

FIGS. 4 and 5 illustrate schematic block diagrams of an entropy encoding unit and entropy decoding unit which process a video signal based on binary arithmetic coding in accordance with embodiments to which the present invention is applied.

FIG. 6 is a diagram for illustrating the coding process with arithmetic at windows of active bits in accordance with an embodiment to which the present invention is applied.

FIG. 7 is a diagram for illustrating the operation of renormalization for arithmetic coding interval in accordance with an embodiment to which the present invention is applied.

FIG. 8 is a diagram for illustrating possible positions of the arithmetic coding interval in accordance with an embodiment to which the present invention is applied.

FIG. 9 is a diagram for illustrating a process of adjusting the arithmetic coding interval in accordance with an embodiment to which the present invention is applied.

FIG. 10 is a flowchart illustrating a method of performing an arithmetic coding with constrained carry operations in accordance with an embodiment to which the present invention is applied.

FIG. 11 is a flowchart illustrating a method of renormalizing the arithmetic coding interval in accordance with an embodiment to which the present invention is applied.

FIG. 12 is a flowchart illustrating a method of adjusting the arithmetic coding interval in accordance with an embodiment to which the present invention is applied.

FIGS. 13 and 14 are flowcharts illustrating another method of adjusting the arithmetic coding interval in accordance with another embodiments to which the present invention is applied.

[Best Mode]

In accordance with an aspect of the present invention, there is provided a method of performing an arithmetic coding for data symbols, comprising: creating an interval for each of the data symbols, the interval being represented based on a starting point and a length of the interval; updating the interval for each of the data symbols; checking whether the updated interval is included in a specific range; and renormalizing the updated interval based on a result of the checking.

In the present invention, the method is further comprised of renormalizing the adjusted interval.

In the present invention, if the updated interval is not included in a specific range, the method is further comprised of selecting one of a top part and a bottom part of the updated interval, wherein the updated interval is adjusted based on a selected part.

In the present invention, the method is further comprised of calculating a threshold point within the updated interval; and comparing a first distance with a second distance, wherein the first distance indicates a length from the threshold point to the top part and the second distance indicates a length from the threshold point to the bottom part, and wherein the updated interval is adjusted based on a result of the comparing step.

In the present invention, if the first distance is smaller than the second distance, a length of the updated interval is set as the second distance.

In the present invention, if the first distance is not smaller than the second distance, a length of the updated interval is set as the first distance, and a starting point of the updated interval is set by the threshold point.

In accordance with another aspect of the present invention, there is provided an apparatus of performing an arithmetic coding for data symbols, which includes a binary arithmetic coding unit, comprising: the binary arithmetic coding unit configured to create an interval for each of the data symbols, the interval being represented based on a starting point and a length of the interval, update the interval for each of the data symbols, check whether the updated interval is included in a specific range, and renormalize the updated interval based on a result of the checking.

[Mode for Invention]

Hereinafter, exemplary elements and operations in accordance with embodiments of the present invention are described with reference to the accompanying drawings. It is however to be noted that the elements and operations of the present invention described with reference to the drawings are provided as only embodiments and the technical spirit and kernel configuration and operation of the present invention are not limited thereto.

Furthermore, terms used in this specification are common terms that are now widely used, but in special cases, terms randomly selected by the applicant are used. In such a case, the meaning of a corresponding term is clearly described in the detailed description of a corresponding part. Accordingly, it is to be noted that the present invention should not be construed as being based on only the name of a term used in a corresponding description of this specification and that the present invention should be construed by checking even the meaning of a corresponding term.

Furthermore, terms used in this specification are common terms selected to describe the invention, but may be replaced with other terms for more appropriate analysis if such terms having similar meanings are present. For example, a signal, data, a sample, a picture, a frame, and a block may be properly replaced and interpreted in each coding process. And, a range, a length, an interval (or coding interval, arithmetic coding interval), and an interval length may be properly replaced and interpreted in each arithmetic coding process.

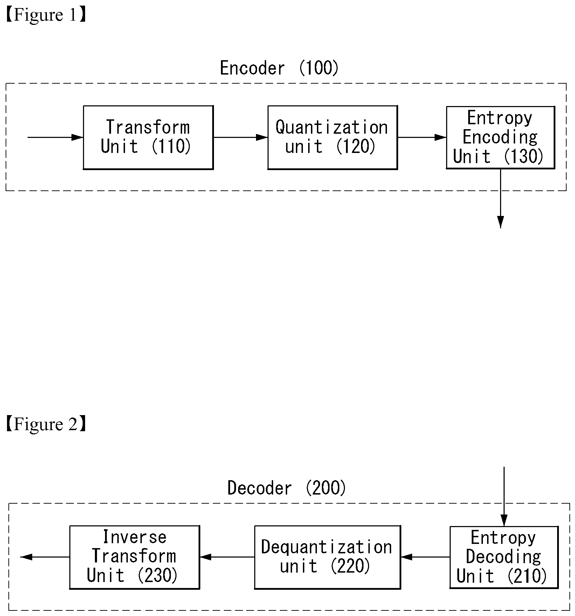

FIGS. 1 and 2 illustrate schematic block diagrams of an encoder and decoder which process a video signal in accordance with embodiments to which the present invention is applied.

The encoder 100 of FIG. 1 includes a transform unit 110, a quantization unit 120, and an entropy encoding unit 130. The decoder 200 of FIG. 2 includes an entropy decoding unit 210, a dequantization unit 220, and an inverse transform unit 230.

The encoder 100 receives a video signal and generates a prediction error by subtracting a predicted signal from the video signal.

The generated prediction error is transmitted to the transform unit 110. The transform unit 110 generates a transform coefficient by applying a transform scheme to the prediction error.

The quantization unit 120 quantizes the generated transform coefficient and sends the quantized coefficient to the entropy encoding unit 130.

The entropy encoding unit 130 performs entropy coding on the quantized signal and outputs an entropy-coded signal. In this case, the entropy coding is the process used to optimally define the number of bits that go into a compressed data sequence. Arithmetic coding, which is one of an optimal entropy coding technique, is a method of representing multiple symbols by a single real number.

In normal coding conditions, the values of the bits in the compressed data buffer are nearly equally probable, and thus very long sequences of outstanding bits are very improbable, because the probability of a sequence of n outstanding bits is $1/2^n$. However, practical implementations of arithmetic coding must be designed to work with any set of input data and symbol probabilities, including those that could accidentally (or intentionally) produce unbounded numbers of outstanding bits.

Encoders designed for software (general-purpose processor) implementation employed a counter of outstanding bits, or simply assumed carries on the compressed data buffer. Whereas, encoders implemented using specialized processors (ASICs), on the other hand, commonly require strong limits on number of cycles required for each operation, and thus cannot accommodate very large variations between the average and worst cases.

One solution for this problem, called "bit stuffing", was developed for arithmetic coders that put out one bit a time: when the number of consecutive "1" bits exceeds a certain limit, a "0" bit may be artificially inserted to limit carry propagation. There is some loss in compression, since those extra bits do not carry any useful information, but it can be kept relatively small.

The problem with this solution is that it is not effective in new implementations of arithmetic coding, which generate sets of full bytes (8-bit words, instead of single bits). The new implementations means a scheme to generate byte-unit information, other than a single bit-unit information, by a arithmetic encoder, when data buses and parallel processing are cheap while it is hard to increase clock speeds.

For those implementations the "bit stuffing" approach can be extended to "byte stuffing," i.e., artificially adding a zero byte to limit carry propagation. While this achieves the desired result, it is not practical because 8 bits that do not convey any information have to be added, and the relative loss in compression becomes excessive.

Accordingly, the present invention defines a technique that enables an implementation of arithmetic coding based on byte-renormalization to be effectively implemented in either general purpose or specialized hardware.

Furthermore, the present invention provides a method to effectively limit the maximum number of changes to the compressed data bytes with little loss in compression.

In an aspect of the present invention, the entropy encoding unit 130 may create an interval for each of the data symbols, and update the interval for each of the data symbols. In this case, the interval may be represented based on a starting point and a length of the interval.

The entropy encoding unit 130 may check whether the updated interval is included in a specific range, and renormalize the updated interval based on a result of the checking.

If the updated interval is included in a specific range, the entropy encoding unit 130 may store the bit positioned within the specific range in a buffer, and renormalize the updated interval.

The decoder 200 of FIG. 2 receives a signal output by the encoder 100 of FIG. 1.

The entropy decoding unit 210 performs entropy decoding on the received signal. For example, the entropy decoding unit 210 may receive a signal including location information of code value, check a symbol corresponding to the location information of code value, and decode the checked symbol.

In arithmetic coding, the decoded sequence may be determined by the code value of the compressed sequence. In decoding process, the code value can be used for decoding the correct sequence.

The entropy decoding unit 210 may search $k^{th}$ correct value from $k^{th}$ normalized code value, and then may compute $(k+1)^{th}$ normalized code value from the $k^{th}$ correct value and $k^{th}$ normalized code value.

Meanwhile, the dequantization unit 220 obtains a transform coefficient from the entropy-decoded signal based on information about a quantization step size.

The inverse transform unit 230 obtains a prediction error by performing inverse transform on the transform coefficient. A reconstructed signal is generated by adding the obtained prediction error to a prediction signal.

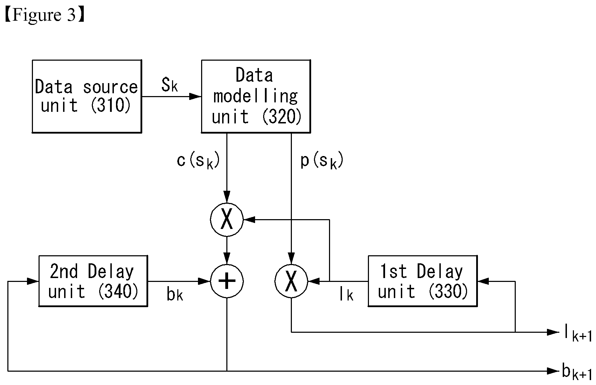

FIG. 3 is a flowchart illustrating sets of operations required for updating arithmetic coding interval data.

The arithmetic coder to which the present invention is applied can include data source unit(310), data modelling unit(320), 1st delay unit(330) and 2nd delay unit.

The data source unit(310) can generate a sequence of N random symbols, each from an alphabet of M symbols, as the following equation 1.

[Equation 1]

$$S = \{s_1, s_2, s_3, \ldots, s_N\}, \qquad s_k \in \{0, 1, 2, \ldots, M-1\}$$

In this case, the present invention assumes that the data symbols are all independent and identically distributed (i.i.d.), with nonzero probabilities as the following equation 2.

[Equation 2]

$$\text{Prob}\{s_k = n\} = p(n) > 0, \qquad k = 1, 2, \ldots, N, n = 0, 1, \ldots, M-1$$

And, the present invention can define the cumulative probability distribution, as the following equation 3.

[Equation 3]

$$c(n) = \sum_{s=0}^{n-1} p(s), \quad n = 0, 1, \ldots, M$$

In this case, c(s) is strictly monotonic, and c(0) = 0 and c(M) = 1.

Even though those conditions may seem far different from what is found in actual complex media signals, in reality all entropy coding tools are based on techniques derived from those assumptions, so the present invention can provide embodiments constrained to this simpler model.

Arithmetic coding consists mainly of updating semi-open intervals in the line of real numbers, in the form $[b_k, b_k + l_k)$, where $b_k$ represents the interval base and $l_k$ represents its length. The intervals may be updated according to each data symbol $s_k$, and starting from initial conditions b1 = 0 and 11 = 1, they are recursively updated for k = 1, 2, ... , N using the following equations 4 and 5.

[Equation 4]

$$l_{k+1} = p(s_k) l_k$$

[Equation 5]

$$b_{k+1} = b_k + c(s_k) l_k$$

In this case, the intervals may be progressively nested, as the following equation 6.

[Equation 6]

$$[b_k, b_k + l_k) \supset [b_i, b_i + l_i), \qquad k = 1, 2, \ldots, i-1, \qquad i = 2, 3, \ldots, N+1$$

As described above, referring to Fig. 3, the data modelling unit(320) can receive a sequence of N random symbols $S_k$, and output the cumulative probability distribution $C(S_k)$ and symbol probability $p(S_k)$.

The interval length $l_{k+1}$ can be obtained by multiplication operation of $S_k$ outputted from the data modelling

unit(320) and $I_k$ outputted from $1^{st}$ delay unit (330).

And, the interval base $b_{k+1}$ can be obtained by addition operation of $b_k$ outputted from $2^{nd}$ delay unit(340) and the multiplication of $C(S_k)$ and $I_k$.

The arithmetic coding to which the present invention is applied can be defined by the arithmetic operations of multiplication and addition. In this case, $b_k$ and $I_k$ can be represented with infinite precision, but this is done to first introduce the notation in a version that is intuitively simple. Later the present invention provides methods for implementing arithmetic coding approximately using finite precision operations.

After the final interval $[b_{N+1}, b_{N+1} + I_{N+1})$ has been computed the arithmetic encoded message is defined by a code value $V \in [b_{N+1}, b_{N+1} + I_{N+1})$. It can be proved that there is one such value that can be represented using at most $1 + log2(I_{N+1})$ bits.

To decode the sequence S using code value $\hat{V}$, the present invention again starts from initial conditions $b_1 = 0$ and $I_1 = 1$, and then use the following equations 7 to 9 to progressively obtain $S_k$, $I_k$, and $b_k$.

[Equation 7]

$$s_k = \left\{ s : c(s) \le \frac{\hat{v} - b_k}{l_k} < c(s+1) \right\}$$

[Equation 8]

$$l_{k+1} = p(s_k) l_k$$

[Equation 9]

$$b_{k+1} = b_k + c(s_k) l_k$$

The correctness of this decoding process can be concluded from the property that all intervals are nested, that $\hat{V} \in [b_{N+1}, b_{N+1} + I_{N+1})$, and assuming that the decoder perfectly reproduces the operations done by the encoder.

The present invention can use symbols $B_k$, $L_k$, and $D_k$ to represent the finite precision values (normally scaled to integer values) of $b_k$, $I_k$ and $\hat{V}$- $b_k$, respectively. the aspects of encoding can be defined by the following equations 10 and 11.

[Equation 10]

$$L_{k+1} = [[c(s_k + 1) L_k]] - [[c(s_k) L_k]]$$

[Equation 11]

$$B_{k+1} = B_k + [[c(s_k) L_k]]$$

In this case, the double brackets surrounding the products represent that the multiplications are finite-precision approximations.

The equation 10 corresponds to equation 4 because *p(s)=c(s + 1) - c(s) (s = 1, 2, ..., M).*

Thus, the decoding process can be defined by the following equations 12 to 14.

[Equation 12]

$$S_k = \{ s : [[c(s) L_k]] \le D_k < [[c(s + 1) L_k]] \}$$

[Equation 13]

$$L_{k+1} = \quad [[c(s_k + 1)L_k]] - [[c(s_k)L_k]]$$

[Equation 14]

$$B_{k+1} = \quad B_k + [[c(s_k)L_k]]$$

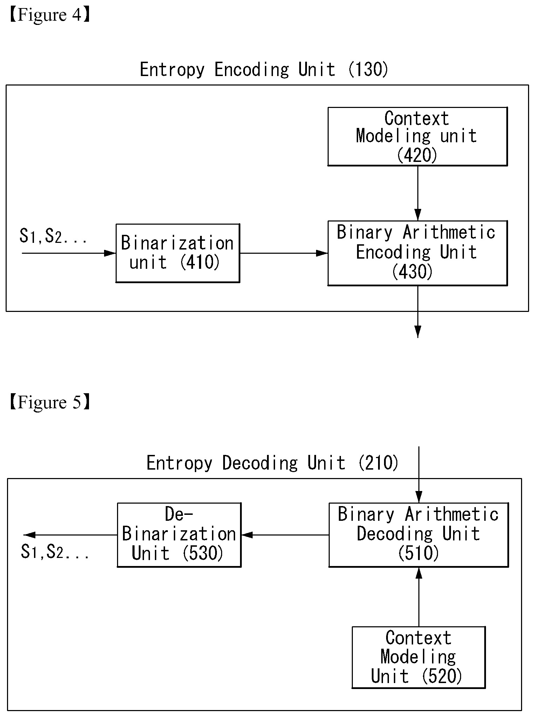

FIGS. 4 and 5 illustrate schematic block diagrams of an entropy encoding unit and entropy decoding unit which process a video signal based on binary arithmetic coding in accordance with embodiments to which the present invention is applied.

Referring to FIG. 4, the entropy encoding unit (130) includes binarization unit(410), context modeling unit(420) and binary arithmetic encoding unit(430).

The binarization unit(410) may receive a sequence of data symbols and output bin string consisted of binarized values 0 or 1 by performing the binarization. The binarization unit(410) may maps the syntax elements to binary symbols (bins). Several different binarization processes, for example, unary (U), truncated unary (TU), kth-order Exp-Golomb (EGk), and fixed length (FL), may be used for the binarization. The binarization process may be selected based on the type of syntax element.

The outputted bin string is tranmitted to context modeling unit(420). The context modeling unit(420) performs probability estimation for entropy-encoding. That is, the context modeling unit(420) may estimate the probability of the bins.

The context modeling unit(420) may provide an accurate probability estimate required to achieve high coding efficiency. Accordingly, it is highly adaptive and different context models can be used for different bins and the probability of that context model may be updated based on the values of the previously coded bins.

Bins with similar distributions may share the same context model. The context model for each bin can be selected based on at least one of the type of syntax element, bin position in syntax element (binIdx), luma/chroma, neighboring information, etc.

The binary arithmetic encoding unit(430) entropy-encodes the outputted bin string and outputs compressed data bits.

The binary arithmetic encoding unit(430) performs arithmetic coding based on recursive interval division.

An interval (or a range), with an initial value of 0 to 1, is divided into two subintervals based on the probability of the bin. The encoded bits provide an offset that, when converted to a binary fraction, selects one of the two subintervals, which indicates the value of the decoded bin.

After every decoded bin, the interval may be updated to equal the selected subinterval, and the interval division process repeats itself. The interval and offset have limited bit precision, so renormalization may be required whenever the interval falls below a specific value to prevent underflow. The renormalization can occur after each bin is decoded.

Arithmetic coding can be done using an estimated probability, or assuming equal probability of 0.5. For bypass coded bins, the division of the range into subintervals can be done by a shift, whereas a look up table may be required for the context coded bins.

Referring to FIG. 5, the entropy decoding unit (210) includes binary arithmetic decoding unit(510), context modeling unit(520) and de-binarization unit(530).

The entropy decoding unit (210) can reversely perform the above encoding process which is explained in the description of FIG. 4.

At binary arithmetic decoding unit(510), the updated interval may be fed back for recursive interval division. The updated context may be fed back for an accurate probability estimate, from binary arithmetic decoding unit(510) to context modeling unit(520).

The context modeling unit(520) may select context based on the type of syntax element. At the entropy decoding unit (210), the decoded bin may be fed back to determine whether to continue processing the same syntax element, or to switch to another syntax element. The context modeling unit(520) may also select context based on the bin position in the syntax element (binIdx).

The de-binarization unit(530) may convert the binary symbol string to multivalued symbols.

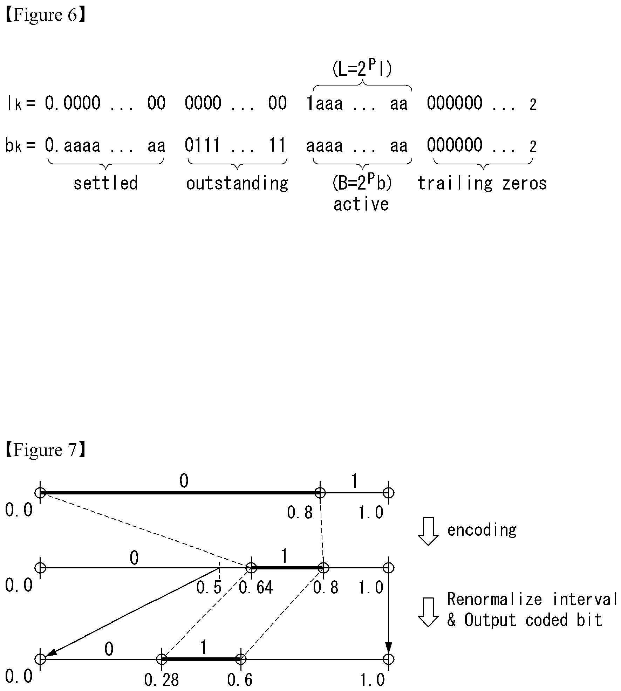

FIG. 6 is a diagram for illustrating the coding process with arithmetic at windows of active bits in accordance with an embodiment to which the present invention is applied.

For a practical implementation of arithmetic coding, the present invention can consider that all additions are done with infinite precision, but multiplications are approximated using finite precision, in a way that preserves some properties. This specification will cover only the aspects needed for understanding this invention.

One important aspect of arithmetic coding is that it can be considered a process of doing arithmetic with infinite precision for addition, but replacing exact multiplications with approximations that guarantee that all operations are done implicitly infinite-precision registers.

Based on this interpretation, the coding process can be done with arithmetic at "windows" of active bits, as shown in FIG. 6. In FIG. 6, symbol 'a' represents an arbitrary bit value, and B represents an value which multiply decimal values of scaled $b_k$ by $2^P$ and make it integer value.

Since interval length $l_k$ decreases, it is necessary to periodically increase P, and re-scale the values of $L = 2^P L$, in a process called renormalization. During renormalization, individual bits or full bytes may be copied from a register word to a buffer that contains the compressed data.

In FIG. 6, the bits called 'settled' and 'outstanding' represent the ones that already have been moved to the buffer with compressed data, and thus may be not actively used in the arithmetic operations. However, one important aspect for this invention that can be observed in FIG. 6 is that there can be any number of outstanding bits that can possibly change due to a binary arithmetic carry from further additions.

FIG. 7 is a diagram for illustrating the operation of renormalization for arithmetic coding interval in accordance with an embodiment to which the present invention is applied.

For a practical implementation of arithmetic coding, since the operation is done in finite-precision registers, when the upper-bit of the interval to be outputted is determined, the bit may be outputted and the renormalization may be performed for extending a width of the interval.

As shown in FIG. 7, thick lines represent the selected intervals. In the second line of FIG. 7, since the bit value of the interval [0.64, 0.8) to be outputted is clearly larger than 0.5, the coded bit '1' may be outputted at this time point, and the section [0.5, 1.0) may be matched to the extended section [0.0, 1.0). Through these steps, the selected intervals may be renormalized.

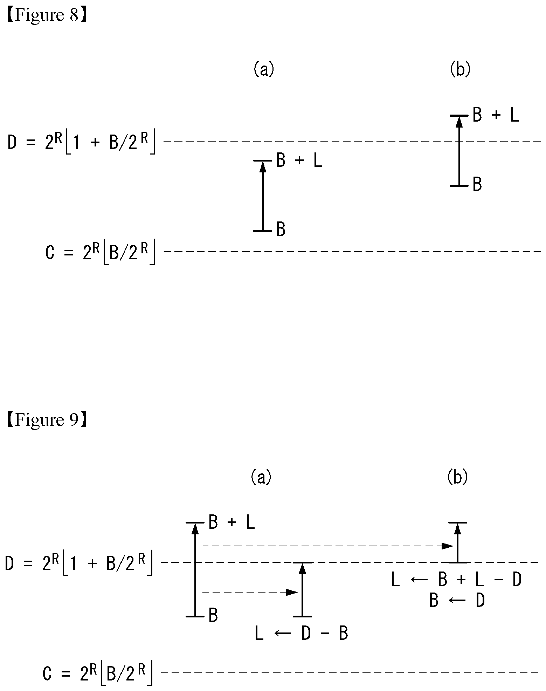

FIG. 8 is a diagram for illustrating possible positions of the arithmetic coding interval in accordance with an embodiment to which the present invention is applied.

In the following explanations, the present invention assumes that arithmetic coding operations may be done with P-bit registers (e.g., P = 32 or P = 64), but to simplify notation, the present invention can define a "carry-precision" of $P_c$ bits, which may include extra memory bytes reserved for carry propagation. For example, an implementation using a processor with registers of P = 32 bits, but with a separate byte reserved for carry propagation is for convenience interpreted as an implementation using registers with $P_c$ = 40 bits. Furthermore, the present invention assumes that the index k in the interval base and length, $B_k$ and $L_k$, is omitted and B and L represent the latest index values.

The present invention proposes a method of adjusting the interval. In this case, the encoder and decoder can keep track of B and L, and both can identify the situations when it is desired to limit carry propagation.

The present invention can perform correct decoding as long as the encoder and decoder use the same rule to change B and L, and that rule does not violate the conditions for correct arithmetic decoding.

In an aspect of the present invention, the finite-precision arithmetic coding needs to renormalize its interval length L when it is smaller than a specific value.

Figure 8 shows a diagram of the possible situations when a specific condition is satisfied. For example, when a condition $L < 2^R$ is satisfied (e.g., R = 24 can be used for 32-bit arithmetic), the possible situations of the interval may be represented as shown in FIG. 8. In this case, the present invention can define the bit position as the following equation 15.

[equation 15]

$$ C = 2^R \left\lfloor \frac{B}{2^R} \right\rfloor, \quad D = 2^R \left\lfloor 1 + \frac{B}{2^R} \right\rfloor $$

[equation 16]

$$ [C, D) \supset [B, B + L) $$

And, if intervals are nested as equation 16, the bits at position R and above are not going to be changed by a carry, and thus can be immediately saved to the compressed data buffer, and the interval can be renormalized.

FIG. 9 is a diagram for illustrating a process of adjusting the arithmetic coding interval in accordance with an embodiment to which the present invention is applied.

If interval [C,D) does not contain interval [B,B +L), then the encoder cannot know if a carry will occur. In this case, the present invention proposes two embodiments.

In the first embodiment, the present invention are not assuming any temporary storage of outstanding bytes, i.e., $P_c$ = P. In the second embodiment, the present invention consider that a small number of outstanding bytes are stored to allow some carries, and $P_c$ > P.

In an aspect of the present invention, the following algorithm, to be used by the encoder and decoder, completely describes the decisions for interval renormalization. In FIG. 9, it can be implicitly determined whether carry is occured according to the choice of top intervals.

The entropy encoding unit may compute the bit position as the below equation 17.

[equation 17]

$$T = 2^R \left\lfloor (B + L - 1)/2^R \right\rfloor$$

The entropy encoding unit may check whether T is larger than B. If T is larger than B, the entropy encoding unit may check whether L is larger than $2^s$. If L is larger than $2^s$, then return. And, the entropy encoding unit may check whether a length of a top part (B+L-T) is smaller than that of a bottom part (T-B), or whether T is equal to 0.

If a length of a top part (B+L-T) is smaller than that of a bottom part (T-B), or T is equal to 0, then the entropy encoding unit may set L as (T-B). Otherwise, the entropy encoding unit may set L as (B+L-T) and set B as T.

And then, the entropy encoding unit may normalize the interval.

In this case, the present invention are assuming L < 2R and S ≤ R, and the condition T = 0 only occurs when there is unsigned integer arithmetic overflow. This is related the condition used to start carry propagation on some implementations.

In the second embodiment, the entropy encoding unit may perform a decision constrained to buffer values. The present invention may store the latest data bytes in short buffers, with possible carries in those bytes only. As explained above, this may be equivalent to having registers with additional bits, and the present invention can use the following algorithm.

The entropy encoding unit may compute the bit position as the above equation 17. In this case, the present invention may assume $P_c$ bits of precision.

And, the entropy encoding unit may check whether T is equal to 0.

If T is equal to 0, the entropy encoding unit may set L as (T-B). And then, the entropy encoding unit may normalize the interval.

As explained, the present invention may adjust the interval to eliminate the possibility of overflow in the extended-precision register, or equivalently overflow in the buffer with outstanding bits.

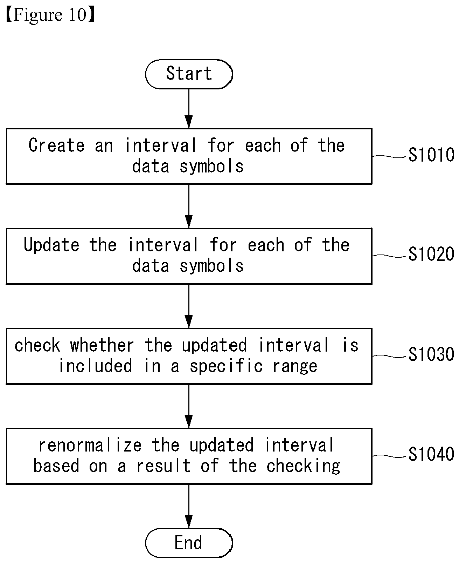

FIG. 10 is a flowchart illustrating a method of performing an arithmetic coding with constrained carry operations in accordance with an embodiment to which the present invention is applied.

The binary arithmetic encoding unit (440) may perform recursive interval division. That is, the interval, with an initial value 0 to 1, can be divided into two subintervals based on the probability of the bin.

The binary arithmetic encoding unit (440) may select one of the two subintervals, which indicates the value of coded bin. The interval can be updated to equal the selected subinterval. In this case, a range and a base of coding interval are represented by finite number of bits, it is necessary to renormalize the interval to prevent precision degradation. And, the upper bits of the base may be outputted as coded bits during renormalization. The coding interval (base, base + range) may be renormalized when a range is smaller than a threshold value.

For the processing of carry propagation and output of coded bits, the coded bits are not outputted until it is confirmed that further carry propagation will not influence bit values.

In an aspect of the present invention, the binary arithmetic encoding unit (440) may create an interval for each of the data symbols (S1010). The created interval for each of the data symbols may be updated based on the probability of the bin (S1020).

The binary arithmetic encoding unit (440) may check if intervals are nested (S1030). For example, the binary arithmetic encoding unit (440) may check whether the updated interval is included in a specific range. That is, referring to FIG. 8, FIG. 8(a) shows that the interval [B,B+L) is included in the specific range [C, D), and FIG. 8(a) shows that the interval [B,B+L) is not included in the specific range [C, D). Thus, as shown in FIG. 8(a), if the interval [B,B+L) is included in the specific range [C, D), the bits at position R and above may not be changed by a carry. Thus, the bits at position R and above may be saved to a buffer.

Then, the binary arithmetic encoding unit (440) may renormalize the updated interval based on a result of the checking (S1040).

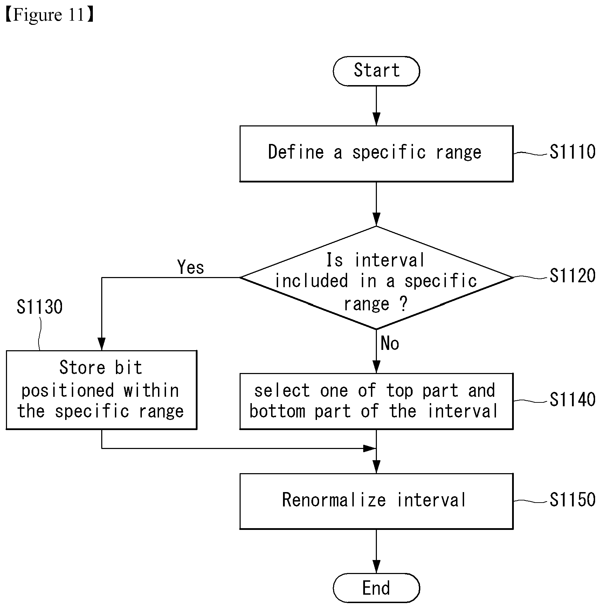

FIG. 11 is a flowchart illustrating a method of renormalizing the arithmetic coding interval in accordance with an embodiment to which the present invention is applied.

In an aspect of the present invention, the binary arithmetic encoding unit (440) may perform interval adjustment.

First, the binary arithmetic encoding unit (440) may define a specific range (S1110). Referring to FIG. 9, the specific range [C,D] may be defined as equation 15.

The binary arithmetic encoding unit (440) may check whether the interval is included in the specific range (S1120). For example, the binary arithmetic encoding unit (440) can check whether the interval corresponds to FIG. 8(a) or FIG. 8(b).

If the interval is included in the specific range, the binary arithmetic encoding unit (440) can store bit positioned within the specific range to a buffer (S1130). Otherwise, the binary arithmetic encoding unit (440) may select one of a top part or bottom part of the interval under a specific condition (S1140).

And, the binary arithmetic encoding unit (440) may renormalize the interval (S1150).

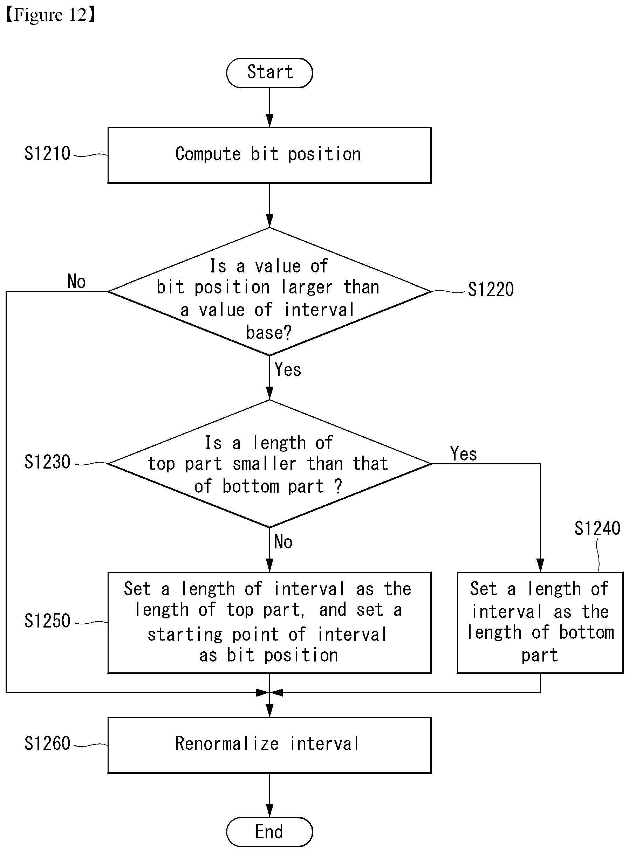

FIG. 12 is a flowchart illustrating a method of adjusting the arithmetic coding interval in accordance with an embodiment to which the present invention is applied.

In an aspect of the present invention, the binary arithmetic encoding unit (440) may perform the decisions for interval renormalization.

The entropy encoding unit may compute the bit position as equation 17 (S1210).

The entropy encoding unit (440) may check whether a value of bit position is larger than a value of interval base (S1220). For example, referring to FIG. 9, the entropy encoding unit (440) may check whether T is larger than B.

If a value of bit position is larger than a value of interval base, the entropy encoding unit (440) may also check whether a length of top part of the interval is smaller than that of bottom part (S1230). For example, referring to FIG. 9, the entropy encoding unit (440) may check whether the length of top part (B+L-T) is smaller than that of bottom part (T-B). Or, the entropy encoding unit (440) may check.

If the length of the top part is smaller than that of the bottom part, then the entropy encoding unit (440) may set a length of the interval as the length of the bottom part (S1240).

Otherwise, the entropy encoding unit (440) may set a length of the interval as the length of the top part, and set a starting point of the interval as bit position (S1250).

Then, the entropy encoding unit (440) may renormalize the interval (S1260).

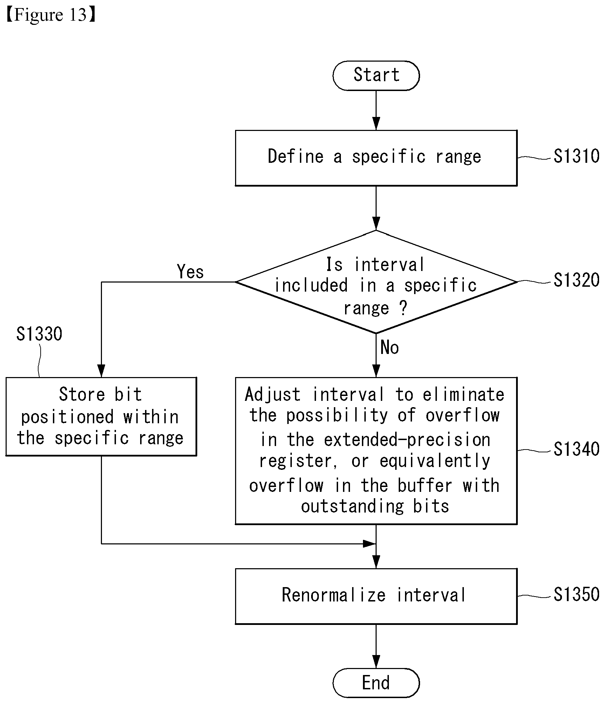

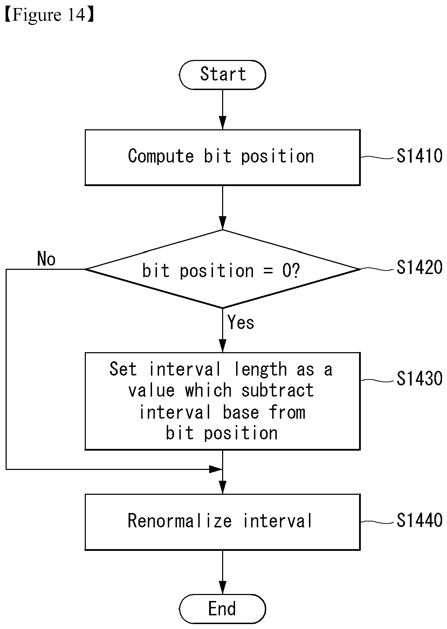

FIGS. 13 and 14 are flowcharts illustrating another method of adjusting the arithmetic coding interval in accordance with another embodiments to which the present invention is applied.

In another aspect of the present invention, the entropy encoding unit (440) may perform a decision constrained to buffer values. The present invention may store the latest data bytes in short buffers, with possible carries in those bytes only. As explained above, this may be equivalent to having registers with additional bits, and the present invention can use the following algorithm.

The binary arithmetic encoding unit (440) may define a specific range (S1310). Referring to FIG. 9, the specific range [C,D] may be defined as equation 15.

The binary arithmetic encoding unit (440) may check whether the interval is included in the specific range (S1320). For example, the binary arithmetic encoding unit (440) can check whether the interval corresponds to FIG. 8(a) or FIG. 8(b).

If the interval is included in the specific range, the binary arithmetic encoding unit (440) can store bit positioned within the specific range to a buffer (S1330). Otherwise, the binary arithmetic encoding unit (440) may adjust the interval to eliminate the possibility of overflow in the extended-precision register, or equivalently overflow in the buffer with outstanding bits (S1340). And, the binary arithmetic encoding unit (440) may renormalize the interval (S1350).

In another embodiment of the present invention, the entropy encoding unit (440) may compute the bit position (S1410), as the above equation 17.

The entropy encoding unit (440) may check whether bit position is equal to 0 (S1420).

If bit position is equal to 0, the entropy encoding unit (440) may set the interval length as a value which subtract interval base from bit position (S1430).

Then, the entropy encoding unit (440) may renormalize the interval (S1440).

As described above, the embodiments explained in the present invention may be implemented and performed on a processor, a micro processor, a controller or a chip. For example, functional units explained in FIGs. 1~5 may be implemented and performed on a computer, a processor, a micro processor, a controller or a chip.

Furthermore, the decoder and the encoder to which the present invention is applied may be included in a multimedia broadcasting transmission/reception apparatus, a mobile communication terminal, a home cinema video apparatus, a digital cinema video apparatus, a surveillance camera, a video chatting apparatus, a real-time communication apparatus, such as video communication, a mobile streaming apparatus, a storage medium, a camcorder, a VoD service providing apparatus, an Internet streaming service providing apparatus, a three-dimensional (3D) video apparatus, a teleconference video apparatus, and a medical video apparatus and may be used to process video signals and data signals.

Furthermore, the processing method to which the present invention is applied may be produced in the form of a program that is to be executed by a computer and may be stored in a computer-readable recording medium. Multimedia data having a data structure according to the present invention may also be stored in computer-readable recording media. The computer-readable recording media include all types of storage devices in which data readable by a computer system is stored. The computer-readable recording media may include a BD, a USB, ROM, RAM, CD-ROM, a magnetic tape, a floppy disk, and an optical data storage device, for example. Furthermore, the computer-readable recording media includes media implemented in the form of carrier waves (e.g., transmission through the Internet). Furthermore, a bit stream generated by the encoding method may be stored in a computer-readable recording medium or may be transmitted over wired/wireless communication networks.

[Industrial Applicability]

The exemplary embodiments of the present invention have been disclosed for illustrative purposes, and those skilled in the art may improve, change, replace, or add various other embodiments within the technical spirit and scope of the present invention disclosed in the attached claims.

**Claims**

1. A method of performing an arithmetic coding for data symbols, comprising:

   creating an interval for each of the data symbols, the interval being represented based on a starting point and a length of the interval;
   updating the interval for each of the data symbols;
   checking whether the updated interval is included in a specific range; and
   adjusting the updated interval to reduce outstanding bits.

2. The method of claim 1, further comprising
   renormalizing the adjusted interval.

3. The method of claim 1, further comprising:

   if the updated interval is not included in a specific range, selecting one of a top part and a bottom part of the updated interval,
   wherein the updated interval is adjusted based on a selected part.

4. The method of claim 3, further comprising:

   calculating a threshold point within the updated interval; and
   comparing a first distance with a second distance,
   wherein the first distance indicates a length from the threshold point to the top part and the second distance indicates a length from the threshold point to the bottom part, and
   wherein the updated interval is adjusted based on a result of the comparing step.

5. The method of claim 4,
   wherein if the first distance is smaller than the second distance, a length of the updated interval is set as the second distance.

6. The method of claim 4,
   wherein if the first distance is not smaller than the second distance, a length of the updated interval is set as the first distance, and a starting point of the updated interval is set by the threshold point.

7. An apparatus of performing an arithmetic coding for data symbols, which includes a binary arithmetic coding unit, comprising:

   the binary arithmetic coding unit configured to
   create an interval for each of the data symbols, the interval being represented based on a starting point and a length of the interval,
update the interval for each of the data symbols,
check whether the updated interval is included in a specific range, and
renormalize the updated interval based on a result of the checking.

8. The apparatus of claim 7,
wherein if the updated interval is included in a specific range, the bit being positioned within the specific range is stored in a buffer and the updated interval is renormalized.

9. The apparatus of claim 7,
wherein if the updated interval is not included in a specific range, the binary arithmetic coding unit is further configured to select one of a top part and a bottom part of the updated interval,
wherein the updated interval is adjusted based on a selected part.

10. The apparatus of claim 9,
wherein the binary arithmetic coding unit is further configured to compare a length of the top part and a length of the bottom part,
wherein the updated interval is renormalized based on a result of the comparison.

11. The apparatus of claim 10,
wherein if the length of the top part is smaller than the length of the bottom part, a length of the updated interval is set as the length of the bottom part.

12. The apparatus of claim 10,
wherein if the length of the top part is not smaller than the length of the bottom part, a length of the updated interval is set as the length of the top part, and a starting point of the updated interval is set as bit position.

【Figure 1】

Encoder (100)

Transform
Unit (110)

Quantization
unit (120)

Entropy
Encoding
Unit (130)

【Figure 2】

Decoder (200)

Inverse
Transform
Unit (230)

Dequantization
unit (220)

Entropy
Decoding
Unit (210)

【Figure 3】

【Figure 4】

Entropy Encoding Unit (130)

```
                          ┌──────────────┐
                          │   Context    │
                          │Modeling unit │
                          │    (420)     │
                          └──────┬───────┘
                                 │
                                 ▼
S1,S2...  ┌──────────────┐  ┌──────────────┐
─────────▶│ Binarization │─▶│Binary Arithmetic│
          │  unit (410)  │  │Encoding Unit │
          └──────────────┘  │    (430)     │
                            └──────┬───────┘
                                   │
                                   ▼
```

【Figure 5】

Entropy Decoding Unit (210)

```
                                   │
                                   ▼
        ┌──────────────┐  ┌──────────────┐
◀───────│     De-      │◀─│Binary Arithmetic│
S1,S2...│ Binarization │  │Decoding Unit │
        │  Unit (530)  │  │   (510)      │
        └──────────────┘  └──────▲───────┘
                                 │
                          ┌──────┴───────┐
                          │   Context    │
                          │  Modeling    │
                          │  Unit (520)  │
                          └──────────────┘
```

【Figure 6】

$$(L=2^{P}l)$$

$l_k = 0.\ 0000\ \ldots\ 00\ \ \ 0000\ \ldots\ 00\ \ \ 1aaa\ \ldots\ aa\ \ \ 000000\ \ldots\ {}_2$

$b_k = 0.\ aaaa\ \ldots\ aa\ \ \ 0111\ \ldots\ 11\ \ \ aaaa\ \ldots\ aa\ \ \ 000000\ \ldots\ {}_2$

settled          outstanding       $(B=2^{P}b)$        trailing zeros
                                    active

【Figure 7】

【Figure 8】

(a)                          (b)

$D = 2^R \lfloor 1 + B/2^R \rfloor$

$C = 2^R \lfloor B/2^R \rfloor$

【Figure 9】

(a)                          (b)

$D = 2^R \lfloor 1 + B/2^R \rfloor$

$L \leftarrow D - B$

$L \leftarrow B + L - D$
$B \leftarrow D$

$C = 2^R \lfloor B/2^R \rfloor$

【Figure 10】

```
                      ┌─────────────┐
                      │    Start    │
                      └──────┬──────┘
                             │
                             ▼
        ┌──────────────────────────────────┐
        │  Create an interval for each of the │──── S1010
        │           data symbols            │
        └──────────────────┬───────────────┘
                           │
                           ▼
        ┌──────────────────────────────────┐
        │  Update the interval for each of the │──── S1020
        │           data symbols            │
        └──────────────────┬───────────────┘
                           │
                           ▼
        ┌──────────────────────────────────┐
        │ check whether the updated interval is │──── S1030
        │     included in a specific range   │
        └──────────────────┬───────────────┘
                           │
                           ▼
        ┌──────────────────────────────────┐
        │  renormalize the updated interval  │──── S1040
        │  based on a result of the checking │
        └──────────────────┬───────────────┘
                           │
                           ▼
                      ┌─────────────┐
                      │     End     │
                      └─────────────┘
```

【Figure 11】

```
                              ┌─────────┐
                              │  Start  │
                              └────┬────┘
                                   │
                                   ▼
                    ┌──────────────────────────────┐
                    │    Define a specific range    │────S1110
                    └──────────────┬───────────────┘
                                   │
                                   ▼
                              ╱──────────╲
          Yes           ╱   Is interval   ╲
     ◄──────────────────  included in a specific  ──────S1120
                         ╲      range ?    ╱
                              ╲──────────╱
  S1130                            │ No
    │                             ▼
    ▼
┌──────────────┐      ┌──────────────────────────────┐
│   Store bit  │      │  select one of top part and  │────S1140
│ positioned within │ │  bottom part of the interval │
│ the specific range │└──────────────┬──────────────┘
└──────┬───────┘                     │
       │                             │
       └──────────────►──────────────┤
                                     ▼
                    ┌──────────────────────────────┐
                    │      Renormalize interval     │────S1150
                    └──────────────┬───────────────┘
                                   │
                                   ▼
                              ┌─────────┐
                              │   End   │
                              └─────────┘
```

【Figure 12】

```
                        ( Start )
                            |
                            v
S1210 ---|  Compute bit position         |
                            |
                            v
                          /              \
              No        /  Is a value of  \
         <------------ <  bit position larger than > --- S1220
              |         \  a value of interval   /
              |          \      base?     /
              |                 |
              |                Yes
              |                 |
              |                 v
              |               /              \
              |             /  Is a length of  \        Yes
              |  S1230 --- <  top part smaller than that > --------|
              |             \  of bottom part ?  /                 |
              |               \              /                     |
              |                    |                               |
              |                   No                          S1240|
              |                    |                               v
              |    |-------------------------------|    |---------------------|
              |    | Set a length of interval as the|   | Set a length of     |
              |    | length of top part, and set a  |   | interval as the     |
              | S1250 | starting point of interval  |   | length of bottom    |
              |    | as bit position               |    | part                |
              |    |-------------------------------|    |---------------------|
              |                    |                               |
              |-------------------->v<-------------------------------|
                                    |
                                    v
S1260 ---|  Renormalize interval         |
                            |
                            v
                         ( End )
```

【Figure 13】

```
                              ( Start )
                                  │
                                  ▼
                   ┌────────────────────────────┐
                   │  Define a specific range   │───S1310
                   └────────────────────────────┘
                                  │
                                  ▼
                              ╱         ╲
                   Yes       ╱ Is interval╲
          ┌───────────────── ╱ included in a ╲ ───S1320
          │                  ╲ specific range?╱
          │                   ╲             ╱
          │                    ╲         ╱
          │                        │ No
          │                        ▼
  ┌──────────────────┐  ┌────────────────────────────┐
  │   Store bit      │  │ Adjust interval to eliminate│
  │ positioned within│  │ the possibility of overflow │
  │ the specific range│  │ in the extended-precision   │───S1340
  └──────────────────┘  │ register, or equivalently   │
   S1330                 │ overflow in the buffer with │
          │              │    outstanding bits         │
          │              └────────────────────────────┘
          │                        │
          └────────────────────────┤
                                    ▼
                   ┌────────────────────────────┐
                   │    Renormalize interval    │───S1350
                   └────────────────────────────┘
                                    │
                                    ▼
                                ( End )
```

21

【Figure 14】

```
                        ┌───────────┐
                        │   Start   │
                        └───────────┘
                              │
                              ▼
          ┌─────────────────────────────────────┐
          │       Compute bit position          │────  S1410
          └─────────────────────────────────────┘
                              │
                              ▼
    No                   ◇─────────────◇
  ◀──────────────────  bit position = 0?  ──────  S1420
  │                      ◇─────────────◇
  │                            │ Yes
  │                            ▼
  │       ┌─────────────────────────────────────┐
  │       │   Set interval length as a          │
  │       │   value which subtract              │────  S1430
  │       │   interval base from                │
  │       │   bit position                      │
  │       └─────────────────────────────────────┘
  │                            │
  └────────────────────────────┤
                               ▼
          ┌─────────────────────────────────────┐
          │       Renormalize interval          │────  S1440
          └─────────────────────────────────────┘
                              │
                              ▼
                        ┌───────────┐
                        │    End    │
                        └───────────┘
```

## INTERNATIONAL SEARCH REPORT

International application No.

**PCT/KR2015/006621**

| A. | CLASSIFICATION OF SUBJECT MATTER |
|---|---|

***H04N 19/13(2014.01)i, H04N 19/50(2014.01)i***

According to International Patent Classification (IPC) or to both national classification and IPC

| B. | FIELDS SEARCHED |
|---|---|

Minimum documentation searched (classification system followed by classification symbols)
H04N 19/13; H03M 7/00; H04N 19/42; H04N 19/172; H04N 19/50

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)
eKOMPASS (KIPO internal) & Keywords: arithmetic coding, interval, range, normalization

| C. | DOCUMENTS CONSIDERED TO BE RELEVANT |
|---|---|

| Category* | Citation of document, with indication, where appropriate, of the relevant passages | Relevant to claim No. |
|---|---|---|
| X | AMIR SAID Introduction to Arithmetic Coding - Theory and Practice. Hewlett Packard Laboratories Report [online]. Hewlett-Packard Laboratory, 2004 [retrieved on 21 August 2015]. Retrieved from the Internet: <URL: http://www.ukma.edu aua/~yubod/teach/coding/HPL-2004-76.pdf>. See pages 5-60 and figures 1.3, 1.5. | 1-12 |
| A | US 8711019 B1 (SU, Guan - Ming et al.) 29 April 2014 See column 12, line 58 - column 13, line 14, claims 1-5 and figure 3. | 1-12 |
| A | YUNWEI JIA et al. A Greedy Renormalization Method for Arithmetic Coding. Communications, IEEE Transactions on (Volume: 55, Issue: 8), 20 August 2007, pp. 1494-1503, ISSN 0090-6778. See pages 1494-1503. | 1-12 |
| A | KR 10-2011-0110274 A (INTEL CORPORATION) 06 October 2011 See paragraphs [0007]-[0045], claims 1-6 and figure 1. | 1-12 |
| A | KR 10-2011-0128226 A (NATIONAL CHIAO TUNG UNIVERSITY) 29 November 2011 See abstract, claims 1-5 and figure 1. | 1-12 |

☐ Further documents are listed in the continuation of Box C.    ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 22 SEPTEMBER 2015 (22.09.2015) | **22 SEPTEMBER 2015 (22.09.2015)** |

| Name and mailing address of the ISA/**KR** | Authorized officer |
|---|---|
| Korean Intellectual Property Office Government Complex-Daejeon, 189 Seonsa-ro, Daejeon 302-701, Republic of Korea | |
| Facsimile No. 82-42-472-7140 | Telephone No. |

Form PCT/ISA/210 (second sheet) (July 2009)

INTERNATIONAL SEARCH REPORT
Information on patent family members

| | International application No. |
|---|---|
| | **PCT/KR2015/006621** |

| Patent document cited in search report | Publication date | Patent family member | Publication date |
|---|---|---|---|
| US 8711019 B1 | 29/04/2014 | US 7982641 B1 | 19/07/2011 |
| KR 10-2011-0110274 A | 06/10/2011 | EP 2507987 A1<br>US 2012-0243605 A1<br>WO 2011-068428 A1 | 10/10/2012<br>27/09/2012<br>09/06/2011 |
| KR 10-2011-0128226 A | 29/11/2011 | US 2011-0285560 A1<br>US 8212696 B2 | 24/11/2011<br>03/07/2012 |

Form PCT/ISA/210 (patent family annex) (July 2009)